# EUROPÄISCHE PATENTSCHRIFT

(11) **EP 2 058 075 B1**
(45) Veröffentlichungstag und Bekanntmachung des Hinweises auf die Patenterteilung: **18.06.2014**
(21) Anmeldenummer: 08022415.7
(22) Anmeldetag: 20.04.2007
(51) Int. Cl.: B23H 3/00, C25D 3/00

(54) **Verfahren zur Oberflächenbehandlung einer elektrisch leitfähigen Substratoberfläche**
Method for treating a surface of an electrically conductive substrate surface
Procédé de traitement de surfaces d'une surface de substrat conductrice électrique

(30) Priorität: 21.04.2006 DE 102006019189; 30.06.2006 DE 102006030323
(43) Veröffentlichungstag der Anmeldung: 13.05.2009
(62) Teilanmeldung aus: 07724433.3
(73) Patentinhaber: Fraunhofer-Gesellschaft zur Förderung der angewandten Forschung e.V., 80686 München (DE)
(72) Erfinder: Quenzer, Hans-Joachim, 25524 Itzehoe (DE); Zwicker, Gerfried, 25524 Itzehoe (DE)
(74) Vertreter: Rösler, Uwe

(56) Entgegenhaltungen:
- US-A- 5 795 653
- US-A1- 2002 197 761

## Beschreibung

### Technisches Gebiet

Die Erfindung bezieht sich auf ein Verfahren zur Oberflächenbehandlung einer elektrisch leitfähigen Substratoberfläche, mit dem es möglich ist Mikro- und Nanostrukturen in die Oberfläche des Substrates einzubringen. Typische Anwendungsbereiche eines derartigen Verfahrens stellen die Einebnung technischer Oberflächen zur Herstellung hochplaner Flächen, bspw. in Form von Spiegeloberflächen, oder die Herstellung mechanisch, elektronisch und/oder optisch wirksamer Strukturen dar.

### Stand der Technik

Gattungsgemäße Verfahren zur Oberflächenbehandlung von Substratoberflächen, stellen entweder an sich bekannte Materialabtrageverfahren, wie beispielsweise nasschemische Ätztechniken, oder Materialabscheideverfahren dar, wie beispielsweise galvanische Verfahren, Sputter- oder Aufdampfverfahren, um nur einige zu nennen. In allen bekannten Verfahren gilt es an einer zu bearbeitenden Substratoberfläche für den jeweiligen Prozess erforderliche Prozessbedingungen zu schaffen, die zum Teil mit großem apparativen Aufwand und damit auch mit hohen Kostenaufwendungen verbunden sind. Beispielsweise gilt es zur Abscheidung von Materialschichten auf einer Substratoberfläche eine entsprechende Vakuumkammer bereitzuhalten, in der unter Vakuumbedingungen bestimmte Materialabscheidungen an der Substratoberfläche vorgenommen werden können. Der Einsatz nasschemischer Abscheideverfahren sowie auch Ätzverfahren setzt die Bereitstellung chemischer Bäder mit darin vorherrschenden elektrostatischen Bedingungen voraus, die neben dem hohen verfahrenstechnischem Aufwand auch zusätzliche Sicherheits- sowie auch Entsorgungsprobleme entstehen lassen.

Auch sind Planarisierungstechniken zur Einebnung von Substratoberflächen bekannt, die auf Basis chemisch mechanischen Polierens erfolgen, insbesondere von Cu-Oberflächen in der Mikroelektronik. Daneben können auch mit Hilfe des so genannten "Reverse Plating" durch Umkehrung eines galvanischen Abscheideprozesses überstehende Materialbereiche abgetragen werden. Auch diese Technik kann zur Einebnung von Materialabscheidungen eingesetzt werden.

### Darstellung der Erfindung

Der Erfindung liegt die Aufgabe zugrunde eine Oberflächenbehandlung an elektrisch leitfähigen Substratoberflächen zu ermöglichen, ohne dabei einen großen apparativen sowie auch kostenrelevanten Aufwand tragen zu müssen, wobei es gilt die Oberflächenbeschaffenheit gezielt zu beeinflussen, d.h. diese zu strukturieren im Sinne einer lokalen Materialabscheidung oder auch einer lokalen Materialabtragung. Das lösungsgemäße Verfahren soll insbesondere zur Planarisierung von Substratoberflächen einsetzbar sein, wie beispielsweise zur Einebnung metallisierte Wafer.

Die der Erfindung zugrunde liegende Aufgabe wird durch ein im Anspruch 1 angegebenen Verfahren gelöst. Den Erfindungsgedanken vorteilhaft weiterbildende Merkmale sind Gegenstand der Unteransprüche sowie der weiteren Beschreibung insbesondere unter Bezugnahme auf die Ausführungsbeispiele zu entnehmen.

Das lösungsgemäße Verfahren zur Oberflächenbehandlung einer elektrisch leitenden Substratoberfläche bedient sich eines festen Ionen leitenden Materials aufweisenden Werkzeuges, das wenigstens bereichsweise mit der elektrisch leitenden Substratoberfläche in Kontakt gebracht wird. Als elektrisch leitende Substratoberfläche ist eine Siliziumwaferoberfläche vorgesehen. Das Ionen leitende Material des Werkzeuges ist ein anionischer Ionenleiter, an den ein elektrisches Potenzial angelegt wird, so dass aus dem anionischen Ionenleiter Anionen austreten, die sich an der Siliziumwaferoberfläche zu einer mit der Siliziumwaferoberfläche reaktiven Verbindung umwandeln, wobei die reaktionsfähige Verbindung mit dem Silizium an der Siliziumwaferoberfläche eine gasförmige Verbindung freisetzt, wodurch die Siliziumwaferoberfläche lokal abgetragen wird.

Das lösungsgemäße Verfahren eröffnet somit in Abhängigkeit von dem zwischen der Substratoberfläche und dem Werkzeug angelegten elektrischen Potenzial sowie in Abhängigkeit der Materialwahl hinsichtlich des Substrats bzw. der Substratoberfläche und dem jeweiligen Werkzeug sowie in Abhängigkeit von der Formbeschaffenheit des Werkzeuges, die letztlich Form und Größe der Kontaktbereiche zwischen Werkzeug und Substratoberfläche bestimmt, die Möglichkeit lokale oder ganzflächige Materialabtragungen an der Substratoberfläche vorzunehmen und dies ohne die Notwendigkeit der Schaffung verfahrenstechnisch komplizierter Prozessbedingungen sowie die hierfür erforderlichen apparativen Voraussetzungen. Vielmehr beruht die lösungsgemäße Oberflächenbehandlung auf rein elektrochemische Vorgänge.

Das Werkzeug, mit dem die lösungsgemäße Oberflächenbehandlung der Siliziumwaferoberfläche durchgeführt wird, besteht aus einem festen anionischen Ionenleiter, der über eine der Substratoberfläche zugewandte Werkzeugoberfläche verfügt, die je nach Oberflächenbehandlungsziel geeignet strukturiert oder unstrukturiert, d.h. plan oder glatt, ausgebildet ist. Die Werkzeugoberfläche wird zur Oberflächenbehandlung fest auf die Substratoberfläche unter Ausbildung eines innigen, vorzugsweise kraftbeaufschlagten Flächenkontaktes angepresst.

Durch die Emission der Ionen an der Substratoberfläche kommt es analog zu Vorgängen in galvanischen Anlagen mit löslicher Anode zu einem kontinuierlichen Materialabtrag, wobei die Substratoberfläche lokal, d.h. ausschließlich an den Kontaktbereichen zum Werkzeug, geätzt wird.

Da das aus einem anionischen Ionenleiter bestehende Werkzeug kraftbeaufschlagt gegen die Substratoberfläche gepresst wird, sinkt das Werkzeug kontinuierlich in die Substratoberfläche solange ein, solange der Ätzvorgang andauert, d.h. solange das Werkzeug kraftbeaufschlagt gegen die Substratoberfläche gepresst wird, während ein elektrisches Potenzial zwischen Substratoberfläche und Werkzeug anliegt. Wie bereits erwähnt kommt es im Unterschied zur Verwendung flüssiger Elektrolyte nur zu einem lokalen Ätzvorgang bzw. Materialabtrag im Kontaktbereich, d.h. in jenen Bereichen, in denen das Werkzeug im Flächenkontakt mit der Substratoberfläche steht. Besonders vorteilhaft ist es, wenn das aus Ionen leitende Material bestehende Werkzeug das zu ätzende Metall vollständig und rückstandsfrei zu transportieren vermag, so dass das Werkzeug keine Änderung hinsichtlich der chemischen Zusammensetzung erfährt.

Durch die Verwendung eines anionischen Ionenleiters als Werkzeugmaterial treten an der Grenzfläche zwischen dem Werkzeug und der Substratoberfläche reaktive Gase auf, gegebenenfalls auch in atomarer Form auf, die unmittelbar zu einer chemischen Reaktion an der Grenzfläche zwischen dem aus Ionen leitenden Material bestehenden Werkzeug und der elektrisch leitenden Substratoberfläche führen. Treten derartige Reaktionsprodukte in gasförmiger Form, beispielsweise bei Verwendung von Fluorionenleitern auf, so kann dieser Prozess für lokale Ätzprozesse genutzt werden.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Ausführungsbeispiel zum lokalen Materialabtrag mittels eines anionischen Ionenleiters für Fluorid Ionen sowie
- Fig. 2: Ausführungsbeispiel zum lokalen Materialabtrag mittels eines anionischen Ionenleiters aus ZrO₂.

### Wege zur Ausführung der Erfindung, gewerbliche Verwendbarkeit

Eine Anwendungsmöglichkeit des lösungsgemäßen Verfahrens sieht den Einsatz von Pyrexglas als Werkzeugmaterial vor, zumal Pyrexglas bei Temperaturen von 300 bis 400°C ein lonenleiter für Alkaliionen darstellt. Eine weitere interessante Eigenschaft von Pyrexglas besteht darin, dass es einerseits mit Silizium im Wege des anodischen Bondens verbunden werden kann, da eine elektrochemische Reaktion im Wege einer anodischen Oxidation in Kontakt mit Silizium stattfindet. Andererseits vermag Pyrexglas Ionen im Wege der Diffusion aufzunehmen, wie beispielsweise Silberionen, wodurch die elektrische Leitfähigkeit von Pyrexglas gezielt eingestellt werden kann. Auf der Grundlage dieser Eigenschaften von Pyrexglas kann das lösungsgemäße Verfahren zur Herstellung optisch wirksamer Strukturen im Mikro- und Nanobereich eingesetzt werden. Wird beispielsweise ein aus Pyrexglas bestehender Wafer mit einer Silberschicht bedampft, der nachfolgend als Substrat dient, auf dessen Silberschicht im weiteren ein als Werkzeug dienender zweiter strukturierter Pyrexglaswafer aufgesetzt wird, so kann durch Anlegen einer elektrischen Spannung zwischen dem Substrat und dem strukturierten Werkzeug die auf dem Substrat aufliegende Silberschicht jeweils in den Kontaktbereichen zu dem aus Pyrexglas bestehenden Werkzeug abgetragen, bzw. vollständig entfernt werden. In einem konkret durchgeführten diesbezüglichen Experiment wurden folgende Prozessparamter gewählt: T= 400°C, elektr. Spannung 100 V, Stromfluß 2 mA/cm², Prozesszeit ca. 200 sec. bei einer Ag-Schichtdicke von ca. 200 nm. Je nach Strukturierung des aus Pyrexglas bestehenden Werkzeuges ist es möglich, auf Waferebene Mikro- und Nanostrukturen herzustellen und entsprechend zu replizieren. Damit eröffnet man sich beispielsweise die Möglichkeit optisch metallische Gitterstrukturen mit Linienbreiten und -abständen von bis hinab zu 20 nm zu replizieren. Derartige Gitterstrukturen können nicht nur als Transmissionsgitter, sondern sogar auch als optische Polarisatoren eingesetzt werden.

Die Replikation dreidimensionaler Silberfilme auf derartigen Pyrexglassubstraten kann auch dazu eingesetzt werden, um sogenannte Gradientenindex-Linsen herzustellen. Hierzu gilt es zwischen dem mit einer Silberschicht bedampften Pyrexglassubstrat und dem entsprechend strukturierten Pyrexglaswerkzeug eine umgekehrt zum vorstehenden Anwendungsfall gepolte elektrische Spannung anzulegen, so dass das Silber in das Glassubstrat hinein diffundieren kann und somit komplexe Diffusionsprofile innerhalb des Pyrexglassubstrates gebildet werden, die letztlich als Gradientenindex-Linsen eingesetzt werden können.

Die vorstehend beschriebenen Verfahrensvarianten beschreiben Materialabtragssowie auch Materialabscheideprozesse, bei denen weder Fremdstoffe gebildet werden, noch entsprechende Hilfsstoffe für eine erfolgreiche Prozessdurchführung bereitzustellen sind.

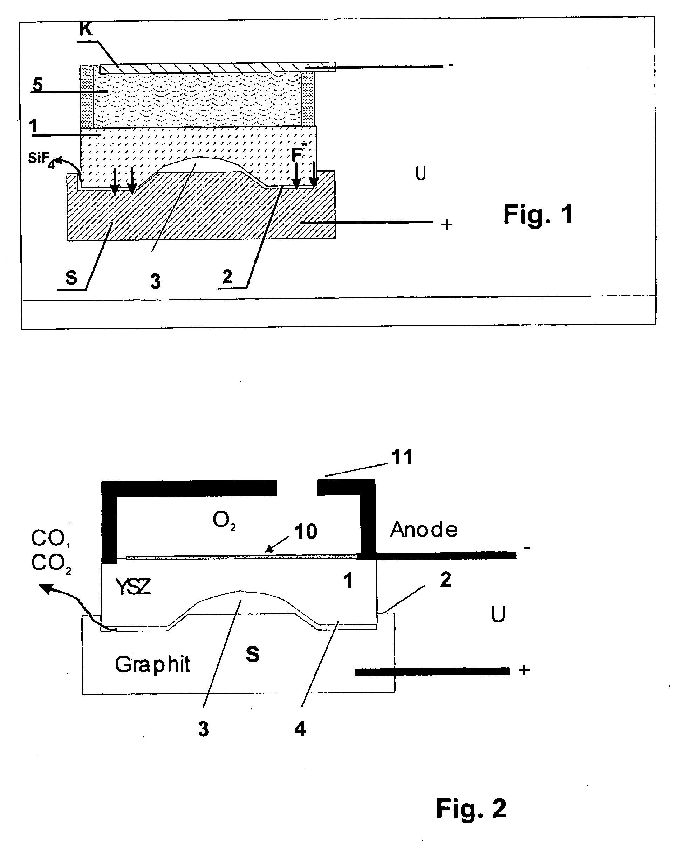

Werden so genannte anionischen Ionenleiter als Werkzeugmaterialien eingesetzt, wie beispielsweise CaF₂, LaF₃ oder auch ZrO₂, eröffnet sich die Möglichkeit bestimmte Substratmaterialien an ihrer Oberfläche reaktiv zu ätzen und dadurch die Substratoberfläche effektiv lokal abzuformen. Die strukturierte Werkzeugoberfläche des aus anionischen Ionenleitern bestehenden Werkzeuges wird auf der Substratoberfläche aufgesetzt, die die Oberfläche eines Siliziumwafers darstellt. Bei Anlegen eines elektrischen Potenzials zwischen dem anionischen Ionenleiter des Werkzeuges und dem Siliziumwafer wandern bei Verwendung eines Fluor enthaltenen Ionenleiters die F⁻-Ionen aus dem Ionen leitenden Werkzeug an die Silizium-Wafer-Oberfläche, die mit dem Ionenleiter in Kontakt stehen und werden dort als Fluor-Atome bzw. Fluor-Moleküle lokal freigesetzt. Diese, sehr reaktiven Produkte reagieren unmittelbar mit dem Silizium zu SiF₄, das gasförmig ist und aus der Grenzfläche zu diffundieren vermag. Diese Situation ist in Figur 1 dargestellt, bei der die strukturierte, Fluor enthaltene Oberfläche des Werkzeuges 1 auf dem Silizium-Wafer S aufsitzt, wobei das Werkzeug 1 rückseitig einen Elektrolyt 5 aufweist, der wiederum mit einer Kathode K verbunden ist. Durch die zwischen dem Werkzeug 1 und dem Siliziumsubstrat S anliegende Potenzialdifferenz wandern Fluorionen an die dem Siliziumsubstrat S zugewandte Oberfläche des Werkzeuges 1, an der die Fluorionen als reaktives Gas F₂ freigesetzt werden und in Gegenwart des oberflächigen Siliziums zu SiF₄ reagieren.

Die Ionenleitfähigkeit des Ionen leitenden Werkzeugmaterials sowie die elektrische Leitfähigkeit des Silizium-Wafers S können überdies erhöht werden, sofern das Temperaturniveau auf Temperaturen zwischen 200 und 300°C erhöht wird. Auf diese Weise kann der reaktive Ätzvorgang an der Siliziumoberfläche sehr deutlich verbessert werden.

Zur Unterstützung des Abtransportes der sich zwischen dem Werkzeug 1 und der Siliziumoberfläche 2 ausbildenden, gasförmigen Reaktionsprodukte bietet es sich ferner an, das Werkzeug 1 zeitweise, vorzugsweise periodisch geringfügig von der Substratoberfläche abzuheben und wieder aufzusetzen. Auf diese Weise können die gasförmigen Reaktionsprodukte seitlich austreten. Dies könnte beispielsweise auch durch zusätzliches Einwirken von Ultra- oder Megaschall auf das Werkzeug bewerkstelligt werden.

Um sicherzustellen, dass eine Verarmung des Ionen leitenden Werkzeuges 1 an Fluorid-Ionen vermieden wird, gilt es kathodenseitig vorzugsweise eine Fluoridhaltige Salzschmelze als Reservoir an Fluor vorzusehen, die gemäß Ausführungsbeispiel in Figur 1 in Form eines Elektrolyts 5 bereitgestellt wird. Hiermit eröffnet sich grundsätzlich die Möglichkeit, refraktive oder auch diffraktive Linsen aus Silizium herzustellen bzw. diese zu replizieren. Unter Verwendung eines Sauerstoff leitenden Materials als Werkzeugmaterial, wie beispielsweise Zirkonium-Oxyd (ZrO₂) können, ganz analog zur Strukturierung von Silizium, auch Materialien wie Graphit oder Diamant dreidimensional strukturiert bzw. repliziert werden.

Besonders eignet sich als Werkzeugmaterial eine Yttrium stabilisiertes Zirkonoxidkeramik (YSZ). Der einfachste Aufbau ist in Figur 2 gezeigt, in der ein geeignet ausgeformtes Werkzeug 1 aus YSZ auf die Substratoberfläche 2 aus Graphit aufgesetzt ist. Die Ionenleitfähige Keramik wird rückseitig mit einer dünnen elektrisch leitfähigen Schicht 10, in diesem Fall aus Platin, beschichte, die dennoch hinreichend durchlässig für Sauerstoff bleibt.
Nach Aufsetzten des Werkzeuges 1 auf dem Graphit wird zwischen dem Graphit und der Rückseite des Werkzeuges eine Spannung U angelegt. Um eine ausreichende Ionische Leitfähigkeit der Keramik zu erreichen ist es notwenig die gesamte Anordnung auf eine Temperatur von ca. 400 °C in einer Sauerstoffhaltigen Atmosphäre aufzuheizen.

Unter diesen Bedingungen ist das Graphit gegenüber Sauerstoff einerseits noch stabil, anderseits aber besitzt die YSZ Keramik des Werkzeuges 1 eine ausreichende Leitfähigkeit und das Graphit ist hinreichen reaktiv um einen Ätzprozess in Gang zu bringen. Die Sauerstoffatmosphäre O₂ sorgt dabei für den eigentlichen Nachschub an Sauerstoff und verhindert die Ausbildung von Verarmungszonen im Ionenleiter. Unter diesen Bedingungen ist es bei einer Spannung um 80V und einer Stromdichte um 2 mA/cm² möglich, eine Ätzrate um 12 - 30 nm /min zu erreichen.
Eine deutlich größere Ätzrate ist allerdings erreichbar. wenn eine höhere Prozesstemperatur angewendet wird. Bei Temperaturen oberhalb von 500°C ist es allerdings unbedingt erforderlich das Graphit vor dem Sauerstoff zu schützten bzw. zu isolieren.
In diesem Fall wird das YSZ Werkzeug 1 rückseitig mit einer keramischen Zuleitung 11 verbunden, deren Innenvolumen mit einer Sauerstoffhaltigen Atmosphäre beaufschlagt wird. Der Raum außerhalb dieses Rohrs wird hingegen mit einem Schutzgas, Stickstoff oder Argon, gespült. Damit wird eine unerwünschte Reaktion des Graphits mit Sauerstoffresten weitgehend vermieden.

Um den lateralen Abtransport der Reaktionsprodukte, CO oder CO₂, insbesondere bei großflächigen Objekten zu erleichtern, kann unterstützend eine vertikale Vibrationsbewegung wie etwa Ultra- oder Megaschall eingeleitet werden.

Besonders interessant erscheint dieses Verfahren im Hinblick auf die Herstellung oder Replikation von Presswerkzeugen aus Glaskohlenstoff. Diese Werkzeuge eignen sich insbesondere als Formeneinsätze in Blankpressverfahren von Linsen für sehr hochschmelzende Werkstoffe wie Kieselglas.

### Bezugszeichenliste

- 1: Werkzeug
- 2: Substratoberfläche
- 3: konkav-förmige Ausnehmung
- 4: Umfangsrand
- 5: Elektrolyt
- S: Substrat
- A: Anode
- K: Kathode
- 10: Platinschicht
- 11: Keramische Zuleitung

## Patentansprüche

1. Verfahren zur Oberflächenbehandlung einer elektrisch teilende Substratoberfläche, bei dem ein festes Ionen leitendes Material aufweisendes Werkzeug wenigstens bereichsweise in Kontakt mit der als Siliziumwaferoberfläche ausgebildeten Substratoberfläche gebracht wird, das als anionischer Ionenleiter ausgebildet ist und an das ein elektrisches Potenzial angelegt wird, so dass aus dem anionischen Ionenleiter Anionen austreten, die sich an der Siliziumwaferoberfläche zu einer mit der Siliziumwaferoberfläche reaktiven Verbindung umwandeln, und
dass die reaktionsfähige Verbindung mit dem Silizium an der Siliziumwaferoberfläche eine gasförmige Verbindung freisetzt, wodurch die Siliziumwaferoberfläche lokal abgetragen wird.

2. Verfahren nach Anspruch 1,
**dadurch gekennzeichnet, dass** als anionischer Ionenleiter CaF₂, LaF₃ verwendet wird.

3. Verfahren nach Anspruch 1 oder 2,
**dadurch gekennzeichnet, dass** der Abtragsvorgang an der Siliziumwaferoberfläche bei Temperaturen zwischen 200 und 300°C durchgeführt wird.

4. Verfahren nach einem der Ansprüche 1 bis 3,
**dadurch gekennzeichnet, dass** als Reservoir an der der Substratoberfläche abgewandten Seite des Werkzeuges ein die Anionen aufnehmender oder abgebender flüssiger Elektrolyt vorgesehen wird.

5. Verfahren nach einem der Ansprüche 1 bis 4,
**dadurch gekennzeichnet, dass** das Werkzeug kraftbeaufschlagt auf die Substratoberfläche gepresst wird.

6. Verfahren nach einem der Ansprüche 1 bis 5,
**dadurch gekennzeichnet, dass** das Werkzeug eine der Substratoberfläche zugewandte und abgewandte Seite aufweist, und
dass das elektrische Potenzial zwischen der Substratoberfläche und der der Substratoberfläche abgewandte Seite des Werkzeuges angelegt wird.

7. Verfahren nach einem der Ansprüche 1 bis 6,
**dadurch gekennzeichnet, dass** bei Verwendung eines Werkzeuges mit einer strukturierten Werkzeugoberfläche, die auf die Substratoberfläche aufgesetzt wird, und durch Anlegen eines elektrischen Potenzials derart, dass Anionen aus der Substratoberfläche in Bereichen, in dienen das Werkzeug mit der Substratoberfläche in Kontakt steht, vom Werkzeug aufgenommen werden, ein lokal begrenzter Materialabtragsvorgang realisiert wird, durch den die Substratoberfläche gleichsam eines lokalen Ätzvorganges strukturiert wird.

8. Verfahren nach einem der Ansprüche 1 bis 7,
**dadurch gekennzeichnet, dass** das Anionen leitende Material des Werkzeuges derart ausgewählt wird, dass die von der Substratoberfläche aufgenommenen Anionen ausschließlich durch das Werkzeug transportiert werden ohne dessen chemische Zusammensetzung zu verändern.

9. Verfahren nach einem der Ansprüche 1 bis 8,
**dadurch gekennzeichnet, dass** als Reservoir an der der Substratoberfläche abgewandten Seite des Werkzeuges ein die Anionen abgebende gasförmiges Reservoir vorgesehen wird.

10. Verfahren nach Anspruch 9,
**dadurch gekennzeichnet, dass** das Reservoir an der der Substratoberfläche abgewandten Seite des Werkzeuges räumlictr von dem Substrat gasdicht getrennt ist.

11. Verfahren nach einem der Ansprüche 1 bis 10,
**dadurch gekennzeichnet, dass** das Werkzeug und/oder die Substratoberfläche Vibrationen ausgesetzt wird, so dass die sich zwischen der Werkzeugoberfläche und der Substratoberfläche ausbildende gasförmige Verbindung entweicht.

## Claims

1. A method for surface treatment of an electrically conductive substrate surface, in which a tool comprising a solid, ion-conducting material is brought into contact with at least portions of the substrate surface, which is a silicon wafer surface, which tool is constructed as an anionic ion conductor to which an electric potential is applied, so that anions are discharged from the anionic ion conductor and are converted at the silicon wafer surface into a compound being reactive with the silicon wafer surface, and
the reactive compound with the silicon on the silicon wafer surface releases a gaseous compound by which the silicon wafer surface is locally removed.

2. The method according to claim 1,
**characterised in that** CaF₂, LaF₃ is used as the anionic ion conductor.

3. The method according to claim 1 or 2,
**characterised in that** the process of removal from the silicon wafer surface is carried out at temperatures between 200 and 300 °C.

4. The method according to any claims 1 to 3,
**characterised in that** a liquid electrolyte that takes up or gives off the anions is provided on the side of the tool facing away from the substrate surface as a reservoir.

5. The method according to any claims 1 to 4, **characterised in that** the tool is pressed against the substrate surface by the application of force.

6. The method according to any claims 1 to 5,
**characterised in that** the tool has one side facing toward the substrate surface, and one side facing away from the substrate surface, and that
the electric potential is applied between the substrate surface and the side of the tool facing away from the substrate surface.

7. The method according to any claims 1 to 6,
**characterised in that** when a tool is used, of which a structured tool surface is placed on the substrate surface, and an electric potential is applied in such manner that anions from the substrate surface are taken up by the tool in areas in which the tool is in contact with the substrate surface, a locally defined material removal process is carried out by which the substrate surface is structured in similar manner to a local etching process.

8. The method according to any claims 1 to 7,
**characterised in that** the anion conducting material of the tool is selected in such manner that the anions that are taken up by the substrate surface are only transported through the tool, without altering the chemical composition thereof.

9. The method according to any claims 1 to 8,
**characterised in that** a gaseous reservoir that releases the anions is provided as a reservoir on the side of the tool facing away from the substrate surface.

10. The method according to claim 9,
**characterised in that** the reservoir on the side of the tool facing away from the substrate surface is separated spatially and insulated in gas-tight manner from the substrate.

11. The method according to any claims 1 to 10,
**characterised in that** the tool and/or the substrate surface is exposed to vibrations so that the gaseous compound that forms between the tool surface and the substrate surface escapes.

## Revendications

1. Procédé pour le traitement de surface d'une surface de substrat électro-conductrice, dans lequel un outil présentant une matière solide conduisant des ions est mis en contact - au moins au niveau de certaines zones - avec la surface de substrat réalisée en tant que surface de tranche de silicium, lequel outil est réalisé en tant que conducteur d'ions anionique et auquel un potentiel électrique est appliqué de sorte que des anions sortent du conducteur d'ions anionique, lesquels se transforment à la surface de la tranche de silicium en une combinaison réactive avec la surface de la tranche de silicium, et
la combinaison à capacité de réaction avec le silicium libérant une combinaison gazeuse à la surface de la tranche de silicium, moyennant quoi la surface de la tranche de silicium est localement enlevée.

2. Procédé selon la revendication 1,
**caractérisé en ce que** l'on utilise du CaF₂, LaF₃ en tant que conducteur d'ions anionique.

3. Procédé selon la revendication 1 ou 2,
**caractérisé en ce que** le processus d'enlèvement à la surface de la tranche de silicium est réalisé avec des températures comprises entre 200 et 300°C.

4. Procédé selon l'une des revendications 1 à 3,
**caractérisé en ce que** l'on prévoit, en guise de réservoir, sur la face de l'outil tournant le dos à la surface du substrat, un électrolyte liquide absorbant ou libérant les anions.

5. Procédé selon l'une des revendications 1 à 4,
**caractérisé en ce que** l'outil est pressé sur la surface du substrat par application d'une force.

6. Procédé selon l'une des revendications 1 à 5,
**caractérisé en ce que** l'outil présente une face tournée vers la surface du substrat et une face tournant le dos à la surface du substrat, et
**en ce que** le potentiel électrique est appliqué entre la surface du substrat et la face de l'outil tournant le dos à la surface du substrat.

7. Procédé selon l'une des revendications 1 à 6,
**caractérisé en ce que**, lors de l'utilisation d'un outil avec une surface d'outil structurée, laquelle est apposée sur la surface de substrat, et en appliquant un potentiel électrique de manière à ce que des anions de la surface de substrat sont absorbés par l'outil dans des zones dans lesquelles l'outil est en contact avec la surface de substrat, on réalise un processus d'enlèvement de matière limité localement, grâce auquel la surface de substrat est structurée à la manière d'un processus de gravure local.

8. Procédé selon l'une des revendications 1 à 7,
**caractérisé en ce que** la matière conduisant les anions de l'outil est sélectionnée de manière à ce que les anions de la surface de substrat absorbés soient exclusivement transportés par l'outil sans modifier la composition chimique de celui-ci.

9. Procédé selon l'une des revendications 1 à 8,
**caractérisé en ce que** l'on prévoit, en guise de réservoir sur la face de l'outil tournant le dos à la surface de substrat, un réservoir gazeux libérant les anions.

10. Procédé selon la revendication 9,
**caractérisé en ce que** le réservoir sur la face de l'outil tournant le dos à la surface de substrat est séparé spatialement du substrat de manière étanche aux gaz.

11. Procédé selon l'une des revendications 1 à 10,
**caractérisé en ce que** l'outil et/ou la surface de substrat est/sont soumis à des vibrations, de sorte que la combinaison gazeuse se formant entre la surface de l'outil et la surface de substrat se dégage.
